# EUROPEAN PATENT APPLICATION

(11) **EP 4 811 335 A1**
(43) Date of publication of application: **23.09.2026**
(21) Application number: 24889964.3
(22) Date of filing: 03.04.2024
(51) Int. Cl.: G09F 9/33, G09F 27/00

(54) **DISPLAY DEVICE**

(30) Priority: 16.11.2023 CN 202323115833 U
(71) Applicant: Unilumin Group Co., Ltd., Shenzhen, Guangdong 518103 (CN)
(72) Inventor: LIU, Xianyi, Shenzhen, Guangdong 518103 (CN); WEI, Tianbo, Shenzhen, Guangdong 518103 (CN); YANG, Kuang, Shenzhen, Guangdong 518103 (CN)
(74) Representative: Herrmann, Daniel
(86) International application number: PCT/CN2024/085813
(87) International publication number: WO 2025/102590

(57) **Abstract**

The present application belongs to the technical field of LED display. Disclosed is a display device. The display device comprises a substrate and a plurality of display assemblies, wherein the plurality of display assemblies are arranged in parallel; each display assembly comprises a plurality of display units sequentially arranged in a reference direction; the substrate is provided with first through structures that run therethrough to a front face and back face of the substrate; the display units are arranged on the substrate; and each first through structure is located between two adjacent display assemblies. The first through structures can allow sound and light to pass therethrough, improving the sound reproduction effect of a screen, and realizing the light transmission function of the screen.

## Description

This application claims priority to Chinese Patent Application No. 202323115833.6, filed with the Chinese Patent Office on November 16, 2023, entitled "DISPLAY DEVICE", which is incorporated herein by reference in its entirety.

### TECHNICAL FIELD

This application relates to the technical field of LED display, and in particular relates to a display device.

### BACKGROUND

With an increasing trend in applications for LED display screens, market demands for LED display screens are higher and higher. In a field of digital movie projection, a loudspeaker can only be arranged around an LED display screen, which causes a large deviation between an audio-visual location information and a creative intention of a director. As a result, a poor sound reproduction effect on-site is produced. However, in an application on light transmission of a display screen, for example, an advertisement screen on a rear window of a taxi, an existing display screen obstructs a transmission of lights due to a substrate of the display screen, as such, a view of a related person is shielded by the existing LED display screen.

### SUMMARY

### TECHNICAL PROBLEM

A main object of embodiments of the present application is to provide a display device to solve a problem that an existing LED display screen cannot transmit lights and sounds.

### TECHNICAL SOLUTION

To achieve the foregoing objective of the present application, the technical solution adopted by the present application is to provide a display device including a substrate and a plurality of display assemblies;
the plurality of the display assemblies are arranged in parallel, and each of the plurality of the display assemblies includes a plurality of display units arranged in sequence in a reference direction; and
a first through structure is provided on the substrate and is extended through a front side and a back side of the substrate, the display units are disposed on the substrate, and the first through structure is located between two adjacent display assemblies.

In an embodiment, the first through structure includes a plurality of first through holes, the plurality of display units are arranged in a matrix on the substrate, and at least every three of the display units are arranged around one of the first through holes.

In an embodiment, the first through hole structure includes a plurality of second through holes, each of the second through holes is located between two adjacent first through holes.

In an embodiment, an aperture of the each of first through hole is greater than an aperture of the second through hole.

In an embodiment, an orthographic projection of each of the display units on the substrate is rectangular, and an angle between a side of the display unit and the reference direction is 45 degrees.

In an embodiment, an orthographic projection of each of the display units on the substrate is square, and a diagonal of the orthographic projection of the display unit is intersected with an axis of the first through hole.

In an embodiment, the first through structure includes a trench hole extending in the reference direction.

In an embodiment, a recessed structure is provided on inner walls of the trench hole, both ends of the recessed structure extend to the front side and the back side of the substrate, respectively, and the recessed structure is located between two adjacent display units.

In an embodiment, an orthographic projection of the recessed structure on the substrate is trapezoidal or arc-shaped.

In an embodiment, a plurality of trench holes are provided between two adjacent display assemblies, and the plurality of trench holes are arranged in the reference direction.

In an embodiment, the first through structure further includes a third through hole, and the third through hole is located between two adjacent trench holes.

In an embodiment, a second through structure is provided on the substrate and is extended through the front side and the back side of the substrate, the second through structure is located between an edge of the substrate and the display assembly, and a side of the second through structure is extended to an edge of the substrate.

In an embodiment, during splicing two substrates, openings of second through structures of two adjacent substrates are oppositely arranged, and the second through structures oppositely arranged enclose to form the first through structure.

In an embodiment, the second through structure includes a notch on a side of the substrate, and an orthographic projection of the notch on the front side of the substrate is semicircular.

In an embodiment, each of the display units includes a carrier plate, a driving chip and a plurality of light-emitting chips; the driving chip and the plurality of light-emitting chips are disposed on the substrate; the carrier plate is connected to the substrate; the driving chip is electrically connected to the plurality of light-emitting chips, respectively; and the plurality of light-emitting chips emit lights in different colors.

### BENEFICIAL EFFECT BRIEF

Advantageous effects of the display device provided in the present application are as follows:
the display assembly on the substrate has the plurality of display units arranged in sequence in the reference direction for displaying images, the first through structure extends through the front side and the back side of the substrate, and the first through structure is located between two adjacent display assemblies, as such, the first through structure allows sounds and lights to pass through the substrate, thereby improving sound reproduction effect the screen and realizing the light transmission function of the screen.

### DESCRIPTION OF THE DRAWINGS

In order that the technical solution in the embodiments of the present application may be more clearly described, the accompanying drawings required for use in the embodiments or the description of the prior art will be briefly described, and it should be understood that the accompanying drawings in the following description are merely some of the embodiments of the present application, and other drawings may be obtained by those skilled in the art without involving any inventive effort.
FIG. 1 is a schematic structural diagram of a display device according to Embodiment 1 of the present application;
FIG. 2 is a schematic structural diagram of a display device according to Embodiment 2 of the present application;
FIG. 3 is another schematic structural diagram of a display device according to Embodiment 2 of the present application;
FIG. 4 is yet another schematic structural diagram of a display device according to Embodiment 2 of the present application;
FIG. 5 is a schematic structural diagram of a display device according to Embodiment 3 of the present application; and
FIG. 6 is a schematic structural diagram of a display unit of a display device.

Reference numerals in the drawings: 10. substrate; 20. display assembly; 21. display unit; 211. carrier plate; 212. light-emitting chip; 213. driving chip; 30. first through hole; 40. second through hole; 50. third through hole; 60. trench hole; 61. recessed structure; 70. second through structure; and X. reference direction.

### DETAILED DESCRIPTION OF THE EMBODIMENTS

To facilitate understanding of the present application, the present application will be described more fully below with reference to the accompanying drawings. Preferred embodiments of the present application are shown in the accompanying drawings. However, the present application may be implemented in many different forms and is not limited to the embodiments described herein. Rather, the purpose of these embodiments is to provide a thorough understanding of the disclosure of this application.

It should be understood that when an element is referred to as being "fixed" to another element, it may be directly on another element or there may be an interconnected element. When an element is considered to be "connected" to another element, it may be directly connected to another element or there may be an interconnected element. As used herein, the terms "vertical", " horizontal" , "left" , "right", and the like are used for purposes of illustration only.

Unless defined otherwise, all technical and scientific terms used herein have the same meaning as commonly understood by one of ordinary skill in the art to which this application belongs. The terminology used in the description of this application is for the purpose of describing specific examples only and is not intended to limit the application. As used herein, the term "and/or" includes any and all combinations of one or more of the relevant listed items.

### Embodiment 1

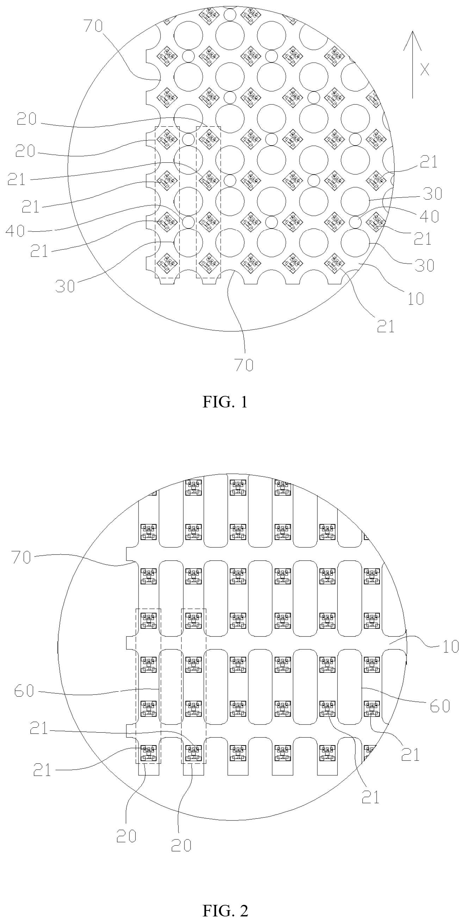

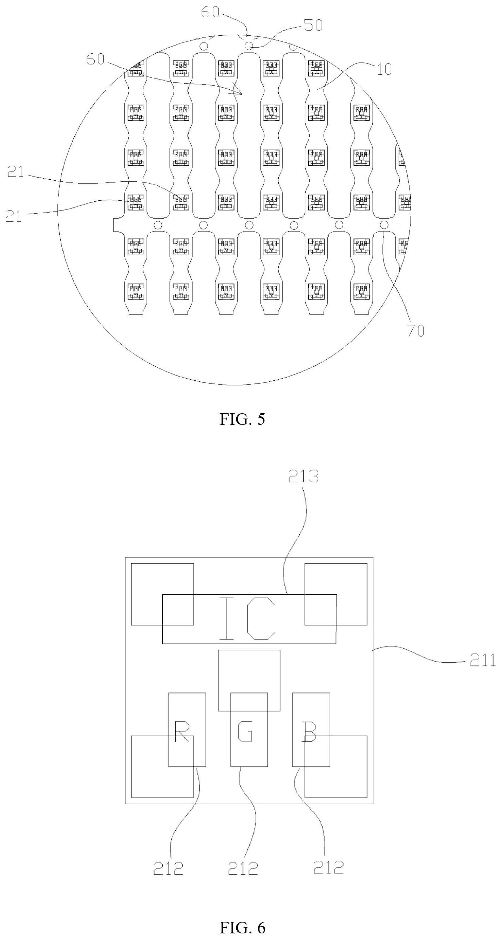

As shown in FIG. 1 and FIG. 6, a display device of the present application including a substrate 10 and a plurality of display assemblies 20 is schematically shown.

Each of the display assemblies 20 includes a plurality of display units 21 arranged in sequence in a reference direction X. The display units 21 are arranged in parallel and are provided on the substrate 10. In the present embodiment, the plurality of display units 21 are arranged in a matrix. The display units 21 are configured to emit lights for the display device to display images.

The substrate 10 has a front side and a back side, and the substrate 10 is provided with a first through structure extending through the front side and the back side, and the first through structure is located between two adjacent display assemblies 20. The first through structure formed on the substrate 10 does not affect the light-emitting effect of the display unit 21, but also allow lights and/or sounds to be transmitted through the substrate 10. Based on this structure, the display units 21 may be provided on the front side of the substrate 10, and a loudspeaker may be provided on the back side of the substrate 10. When the loudspeaker generates sounds, a user in front of the substrate 10 can sense that the sounds are emitted from the display device, thereby achieving a better sound reproduction effect. In addition, the display device may be arranged at a rear window of a taxi or a glass window of a subway train to display images without affecting the light transmission requirement as much as possible.

Specifically, the first through structure includes a plurality of first through holes 30. The first through holes 30 may be circular holes, and at least every three display units 21 are arranged around one first through hole 30. Since the plurality of display units 21 in the present embodiment are arranged in a matrix on the substrate 10, every four display units 21 are arranged around one first through hole 30. In case that the plurality of first through holes 30 are provided, the plurality of first through holes 30 are arranged in a matrix on the substrate 10. In order to further improve an opening rate of the substrate 10 (the opening rate is equal to a total area of the first through structure divided by a total area of the front side or the back side of the substrate 10), the first through structure further includes a plurality of second through holes 40, and each of the second through holes 40 is located between two adjacent first through holes 30. The second through holes 40 may be circular holes, and an aperture of each of the first through holes 30 is greater than an aperture of each of the second through holes 40.

Further, an orthographic projection of the display unit 21 on the substrate 10 is rectangular, and an angle between either side of the display unit 21 and the reference direction is 45 degrees. Based on this structure, the aperture of the first through hole 30 can be further increased to improve the transmittance of the substrate 10. The orthographic projection of the display unit 21 on the substrate 10 may be square, as such, a diagonal of the square of the display unit 21 is intersected with an axis of the first through hole 30.

As shown in FIG. 6, the display unit 21 includes a carrier plate 211, a driving chip 213, and a plurality of light-emitting chips 212. The driving chip 213 and the plurality of light-emitting chips 212 are arranged on the carrier plate 211, and the plurality of light-emitting chips 212 emit lights in different colors. The light-emitting chips 212 preferably have three types. Each carrier plate 211 has the light-emitting chips 212 of three types, and the light-emitting chips 212 are configured to emit red lights, green lights, and blue lights, respectively. The combination of the three lights can be mixed into a plurality of different colors. The carrier plate 211 is connected to the substrate 10, and the driving chip 213 is electrically connected with the plurality of light-emitting chips 212, respectively. The driving chip 213 is configured to control the brightness of each of the light-emitting chips 212. The display unit 21 is packaged based on the above structure.

In order to splice a plurality of display devices into a larger display screen, the substrate 10 is provided with a second through structure 70 extending through the front side and the back side of the substrate 10, and the second through structure 70 is located between an edge of the substrate 10 and the display assembly 20 closest to the edge. A side of the second through structure 70 extends to the edge of the substrate 10. When the substrates 10 of the plurality of display devices are spliced to each other, openings of second through structures 70 of two adjacent substrates 10 are oppositely arranged, and the second through structures 70 oppositely arranged on two adjacent substrates 10 enclose to form the first through structure. It maintains an integrity of the first through structure at splicing junctions of the two substrates 10, to avoid an absence of the first through structure at the splice junctions of the two substrates 10. For example, the second through structure 70 includes a notch on a side of the substrate 10, and an orthograph projection of the notch on the front side of the substrate 10 is semicircular. When the two substrates 10 are spliced to each other, the notches of the two substrates 10 are oppositely disposed, and the two oppositely disposed notches enclose a circular hole of which size corresponds to the first through hole 30.

### Embodiment 2

As shown in FIG. 2, the present embodiment differs from the first embodiment in that the first through structure includes a trench hole 60, and the trench hole 60 extends in the reference direction. The trench hole 60 is provided to make the transmittance of the substrate 10 of the present embodiment higher than the transmittance of the substrate 10 of the first embodiment.

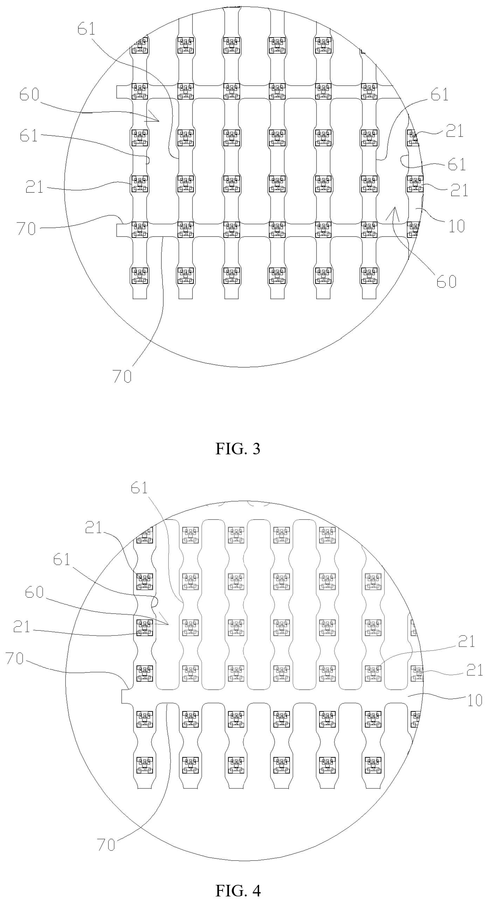

As shown in FIG. 3, to further improve the transmission of the substrate 10, a recessed structure 61 is provided on inner walls of the trench hole 60. Both ends of the recessed structure 61 extend to the front side and the back side of the substrate 10, respectively, and the recessed structure 61 is positioned between two adjacent display units 21. Thus, the recessed structure 61 is provided to enlarge an opening area of the trench hole 60. As shown in FIG. 3 and FIG. 4, an orthographic projection of the recessed structure 61 on the substrate 10 is preferably trapezoidal or arc-shaped.

A plurality of trench holes 60 may be provided between two adjacent display assemblies 20. In case that the plurality of trench holes 60 are provided, the plurality of trench holes 60 are all arranged in the reference direction.

### Embodiment 3

As shown in FIG. 5, the present embodiment differs from the second embodiment in that, a plurality of trench holes 60 are provided between two adjacent display assemblies 20, the first through structure further includes a third through hole 50, and the third through hole 50 is positioned between two adjacent trench holes 60, which further improves the transmittance of the substrate 10.

As above, the display assembly 20 on the substrate 10 has the plurality of display units 21 arranged in sequence in the reference direction for displaying images, the first through structure extends through the front side and the back side of the substrate 10, and the first through structure is located between two adjacent display assemblies 20. The first through structure allows sounds and lights to pass through the substrate 10, thereby improving sound reproduction effect the screen and realizing the light transmission function of the screen.

The above description is merely an example of the present application, and is therefore not intended to limit the scope of the present application, but is equally intended to be included within the protection scope of the present application whenever equivalent structural or equivalent flow changes are made using the contents of the description and drawings of the present application, or when applied directly or indirectly to related technical fields.

## Claims

1. A display device, **characterized by** comprising a substrate and a plurality of display assemblies;
wherein the plurality of the display assemblies are arranged in parallel, and each of the plurality of the display assemblies comprises a plurality of display units arranged in sequence in a reference direction; and
a first through structure is provided on the substrate and is extended through a front side and a back side of the substrate, the display units are disposed on the substrate, and the first through structure is located between two adjacent display assemblies.

2. The display device according to claim 1, **characterized in that** the first through structure comprises a plurality of first through holes, the plurality of display units are arranged in a matrix on the substrate, and at least every three of the display units are arranged around one of the first through holes.

3. The display device according to claim 2, **characterized in that** the first through hole structure comprises a plurality of second through holes, each of the second through holes is located between two adjacent first through holes.

4. The display device according to claim 3, **characterized in that** an aperture of the each of first through hole is greater than an aperture of the second through hole.

5. The display device according to any one of claims 1 to 4, **characterized in that** an orthographic projection of each of the display units on the substrate is rectangular, and an angle between a side of the display unit and the reference direction is 45 degrees.

6. The display device according to any one of claims 1 to 4, **characterized in that** an orthographic projection of each of the display units on the substrate is square, and a diagonal of the orthographic projection of the display unit is intersected with an axis of a first through hole.

7. The display device according to any one of claims 1 to 6, **characterized in that** the first through structure comprises a trench hole extending in the reference direction.

8. The display device according to claim 7, **characterized in that** a recessed structure is provided on inner walls of the trench hole, both ends of the recessed structure extend to the front side and the back side of the substrate, respectively, and the recessed structure is located between two adjacent display units.

9. The display device according to claim 8, **characterized in that** an orthographic projection of the recessed structure on the substrate is trapezoidal or arc-shaped.

10. The display device according to any one of claims 7 to 9, **characterized in that** a plurality of trench holes are provided between two adjacent display assemblies, and the plurality of trench holes are arranged in the reference direction.

11. The display device according to any one of claims 7 to 10, **characterized in that** the first through structure further comprises a third through hole, and the third through hole is located between two adjacent trench holes.

12. The display device according to any one of claims 1 to 11, **characterized in that** a second through structure is provided on the substrate and is extended through the front side and the back side of the substrate, the second through structure is located between an edge of the substrate and the display assembly, and a side of the second through structure is extended to an edge of the substrate.

13. The display device according to claim 12, **characterized in that** during splicing two substrates, openings of second through structures of two adjacent substrates are oppositely arranged, and the second through structures oppositely arranged enclose to form the first through structure.

14. The display device according to claim 12 or 13, **characterized in that** the second through structure comprises a notch on a side of the substrate, and an orthographic projection of the notch on the front side of the substrate is semicircular.

15. The display device according to any one of claims 1 to 14, **characterized in that** each of the display units comprises a carrier plate, a driving chip and a plurality of light-emitting chips; the driving chip and the plurality of light-emitting chips are disposed on the substrate; the carrier plate is connected to the substrate; the driving chip is electrically connected to the plurality of light-emitting chips, respectively; and the plurality of light-emitting chips emit lights in different colors.
